# EUROPEAN PATENT SPECIFICATION

(11) **EP 0 555 496 B1**
(45) Date of publication and mention of the grant of the patent: **26.03.1997**
(21) Application number: 91830294.4
(22) Date of filing: 03.07.1991
(51) Int. Cl.: H01L 27/082

(54) **Lateral bipolar transistor structure including an integrated control circuit and integrated power transistor and associated manufacturing process**
Laterale Bipolartransistorstruktur mit integriertem Kontrollschaltkreis und integriertem Leistungstransistor und deren Herstellungsprozess
Structure de transistor bipolaire latérale avec circuit intégré de contrôle et transistor de puissance intégré et leur procédé de fabrication

(43) Date of publication of application: 18.08.1993
(73) Proprietor: CONSORZIO PER LA RICERCA SULLA MICROELETTRONICA NEL MEZZOGIORNO, 95121 Catania (IT)
(72) Inventor: Zambrano, Raffaele, I-95037 San Giovanni La Punta CT (IT)
(74) Representative: Arena, Giovanni

(56) References cited:
- EP-A- 0 351 331
- IEDM TECHNICAL DIGEST 1983, NEW YORK USA pages 408 - 411; R. S. WRATHALL ET AL.: 'INTEGRATED CIRCUITS FOR THE CONTROL OF HIGH POWER'

## Description

The object of the present invention is a bipolar transistor structure with lateral current flow for a monolithic semiconductor device including an integrated control circuit and at least one integrated power transistor in the same chip and a associated manufacturing process.

In known monolithic devices of the above mentioned type the control circuit usually comprises several low voltage npn transistors and a horizontal insulation region of type p achieved by selective dopant implantation and subsequent diffusion. This region gives rise together with the collector region of the power transistor and the collector region of a transistor of the integrated control circuit to an npn parasite transistor the firing of which must be avoided.

A structure of an integrated circuit with improved insulation among components is described in EP-A-351331. According to said structure each component is realized inside a caisson region of a first type of conductivity laterally insulated from the other caisson regions by insulating walls, and formed on the surface of a layer of a second type of conductivity, said layer being realized on a substrate which is even of the second type of conductivity but with a higher concentration of dopant. The object of the present invention is to provide a new monolithic semiconductor device comprising a control circuit and at least one integrated power transistor in the same chip, which prevents firing of the parasite npn transistor by minimizing the resistance between its base and the insulation terminal, normally grounded, and its current gain as well.

Said monolithic semiconductor device comprises integrated in the same chip:
- at least one power transistor,
- one control circuit including a bipolar transistor with lateral current flow and which comprises
- a first buried region (3) and second regions (6) joining the perimeter of said first buried region (3) with the surface of the chip, having both a first type of conductivity and both formed in a substrate of a second conductivity type and both acting as insulation regions of said control circuit,
- a third region (4) of the second type of conductivity opposite the first one and within said first and second regions (3,6) and reaching the surface of the chip.
- a fourth region (8) having said first type of conductivity, acting as the base region and provided within said third region (4) and extending from the chip surface,
- a fifth region (12) having the second type of conductivity, provided in said fourth region (8), acting as the collector region and extending from the chip surface, and
- a sixth region (11) having the second type of conductivity, provided in said fourth region (8), acting as the emitter region and extending from the chip surface.

The structure of said bipolar transistor with lateral current flow is characterized by the presence of:
- a seventh region (10) extending from the chip surface and having the first type of conductivity and being more highly doped than said fourth region (8), having annular geometry, surrounding and being in contact with the perimeter of said fourth region (8) and with channel-stop function.

A manufacturing process for said monolithic semiconductor device is set out in claims 7 and 8, respectively. Preferred embodiments are defined in the dependent claims.

The characteristics of the invention will be clarified by the description given below and the annexed drawings of examples of a nonlimiting embodiment wherein:
- FIG.1a: shows the structure of a monolithic semiconductor device in accordance with the known art,
- FIG.1b: shows the equivalent circuit of the structure of FIG. 1a,
- FIG.2: shows the structure of a first example of a monolithic semiconductor device in accordance with the present invention,
- FIGS.3 to 6: show the steps of a process of an embodiment of the structure of FIG. 2,
- FIG.7: shows the equivalent circuit of the structure of FIG. 2,
- FIG. 8: shows the structure of a second example of a monolithic semiconductor device in accordance with the present invention,
- FIGS. 9-12: show some steps of a process realizing the structure of FIG. 8, and
- FIG.13: shows the structure of a third example of a monolithic semiconductor device in accordance with the present invention.

A structure of a monolithic semiconductor device in accordance with the known art (as described e.g. in EP-B-322040) is shown in FIG. 1a.

For the sake of simplicity a single component of the control circuit (a low voltage npn transistor with vertical current flow) and a single power transistor (also an npn transistor) are shown.

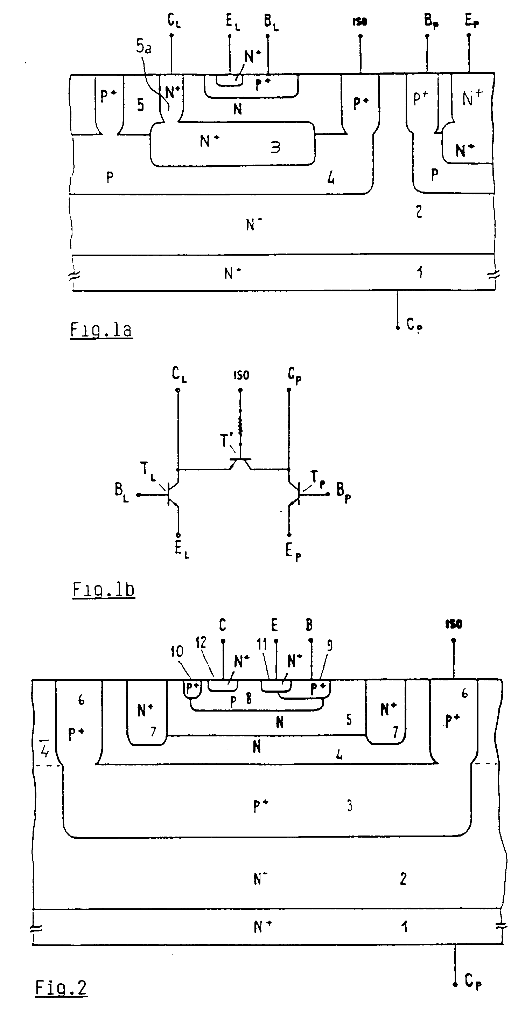

FIG. 1b shows the electrical equivalent of the above structure. In addition to the transistor Tp and the transistor Tl of the control circuit it shows the npn parasite transistor T' (whose collector, base and emitter regions are made up respectively of the regions 1+2, 4 and 3+5+5a), which are typical of the insulation structure, and the resistance between its base and the insulation terminal ISO, which is generally grounded. It is therefore necessary to avoid that this transistor (as also the reverse) goes into conduction, and for this purpose it is necessary to minimize:
- resistance between the base of said transistor and the insulation terminal of the monolithic device, normally grounded;
- its current gain.

The values of these two magnitudes are both rather high and their reduction by optimization of the process parameters is only partial.

As may be seen in FIG. 2, in which the power transistor is not shown, a structure in accordance with the present invention differs from the known one of FIG. 1 because of the elimination of the buried type N layer (buried layer 3 of FIG. 1a) and the fact that the npn transistor of the control circuit has horizontal current flow instead of vertical (as in the npn transistor of FIG. 1a).

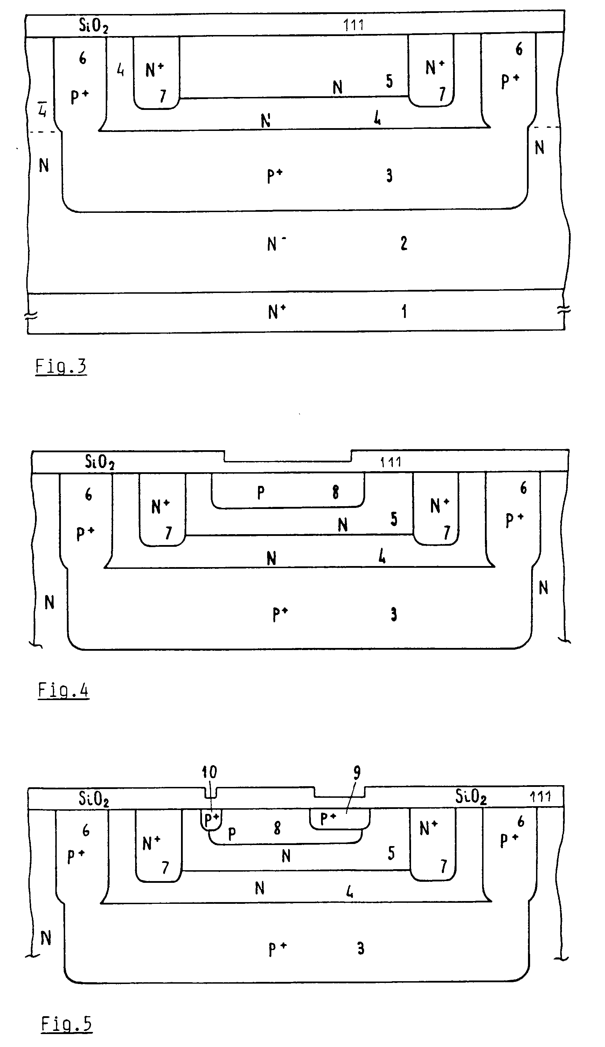

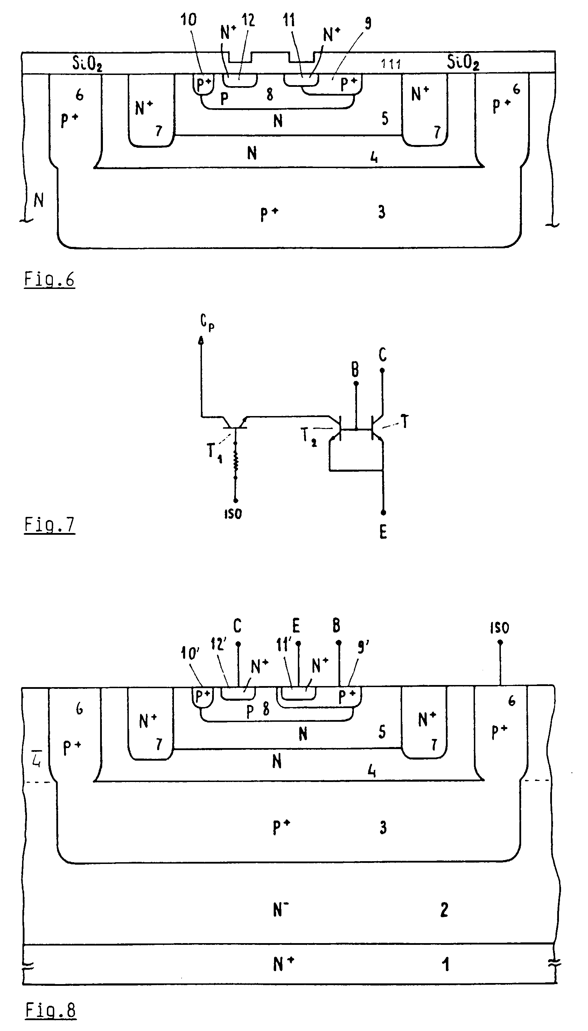

The process sequence according to the present invention is shown schematically in figures 3 to 6 wherein for the sake of simplicity a single component 7 of the control circuit (a low voltage npn transistor) is shown. Said sequence consists of:
1) Epitaxial growth of a layer 2 of type N on a substrate 1 having the same type of conductivity (FIG. 3).
2) Implantation of type P dopant on the preceding epitaxy 2 of type N (FIG. 3).
3) Diffusion of the type P dopant as set forth in step 2) above to create a buried region 3 of type P designed to act as a horizontal insulation region of the control circuit (FIG. 3).
4) Provision of a second epitaxial growth of type N (layer 4 of FIG. 3).
5) Implantation and subsequent diffusion of type N dopant to create the N-well 5 (FIG. 3).
6) Implantation and subsequent diffusion of type P dopant to define the insulating regions 6 enclosing, together with region 3, a region 4.
7) Implantation and subsequent diffusion of type N dopant to provide the regions 7 of type N channel-stop (FIG. 3).
8) Oxidation of the surface (layer of SiO₂ indicated by reference number 111 in FIG. 3) and opening of a window, implantation and diffusion of type P dopant for formation of the base region 8 (FIG. 4).
9) Formation of a type P region with annular geometry following the perimeter of the base region 8 formed in step 8 for definition of the base contact and channel stop region 9 and channel-stop region 10 (FIG. 5).
10) Opening of two windows in the base region, implantation and diffusion of type N dopant for formation of the emitter region 11 and collector region 12 (FIG. 6).

The latter step is followed by definition of the contact areas and metallization of the front and back of the slice.

It is pointed out that between the above steps 3) and 4) there is normally inserted a step of implantation and subsequent diffusion of a type N dopant to provide a buried type N layer outside the region designed to house the npn transistor with lateral current flow which is the object of the present invention, a buried layer designed for the embodiment of other components in the control circuit and provided in accordance with the known art.

FIG. 7 shows the equivalent electrical diagram of the embodied structure. T represents therein the npn lateral transistor which is the object of the present invention, T1 the parasite npn transistor (whose collector, base and emitter regions consist of the regions 1+2, 3 and 4+5+7 respectively of FIG. 2), and T₂ the associated vertical npn transistor (whose collector, base and emitter regions consist of the regions 5, 8 and 11 respectively).

There can be noted the main advantage which consists of the enormous reduction of current gain of the parasite npn transistor (gain which, it is recalled, is equal to the product of the injection efficiency and the transport factor in the base).

Indeed, both the injection efficiency (since the emitter region is of type N instead of N+) and the transport factor in the base are reduced since the quantity of electrically active dopant contained in this region is considerably increased following elimination of the buried type N layer (region 3 of FIG. 1a).

The latter circumstance is also extremely useful in reduction of the base resistance, which also minimizes potential drops resulting from the passage of current and hence the probability of active region polarization of the parasite npn transistor.

Finally, again for the same reasons, the gain of the reverse npn parasite transistor i.e. the gain obtained by exchanging the emitter and collector terminals, is substantially reduced.

As a variation on the invention there can be provided a selective enrichment of the base region around the emitter, obtaining in this manner the following advantages:
- limitation of the gain of the associated vertical npn transistor (see FIG. 7 again),
- increase in Vearly,
- minimization of the distance of the emitter and collector regions necessary to avoid punch-through,
- creation of a concentration gradient in the base to improve the gain characteristics, current range and frequency response.

In the process which is the object of the variation the emitter region and the base region surrounding the emitter can be the selfaligning type.

The structure of the lateral npn transistor with base enrichment around the emitter is shown in FIG. 8.

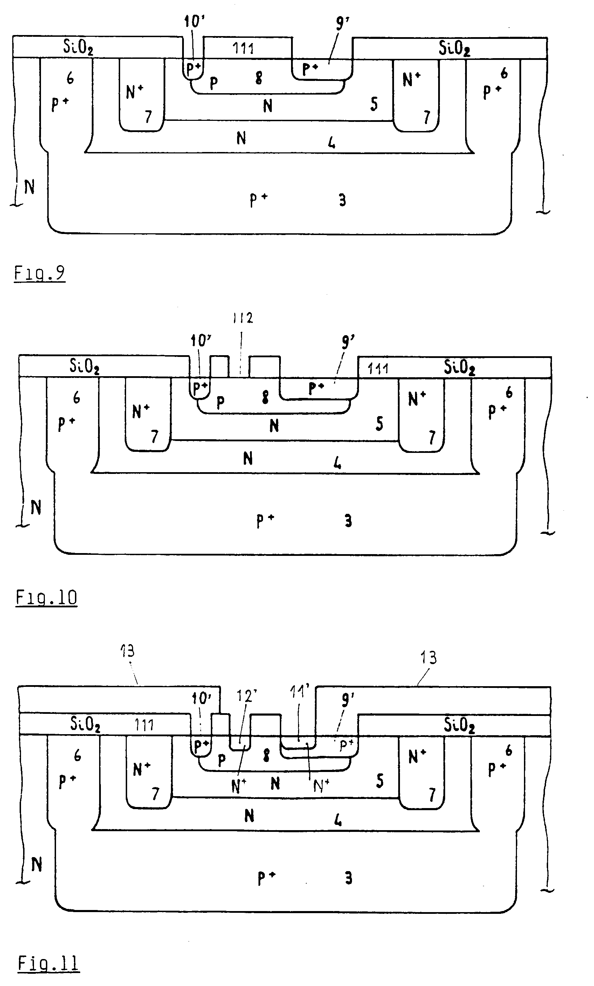

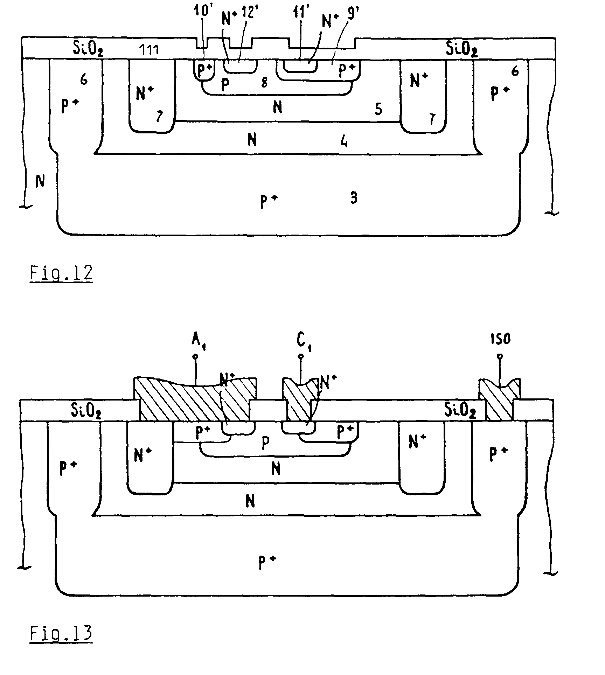

A possible sequence of the process which is the object of the present variation is illustrated in FIGS. 9 to 12. Said process coincides with that previously described for the structure of FIG. 3 in the first steps and specifically steps 1 to 8. As concerns the subsequent steps it continues as follows:
9) Definition and implantation of a type P region with annular geometry following the perimeter of the base region 8 defined in the previous step 8 for embodiment of the region 9' for base and channel stop contact, and channel stop 10' (FIG. 9).
10) Definition of a window 112 in the layer 111 of SiO₂ overlying the base region defined in the above step 8 for formation of the collector region (FIG. 10).
11) Definition and implantation through resist (layer 13) and the oxide layer (layer 111) of two type N regions for formation of the emitter region 11' and the collector region 12' (FIG. 11), and
12) removal of the layer 13 of resist, diffusion of the emitter and collector regions and base enrichment (FIG. 12).

There follow definition of the contact areas and metallization of the front and back of the slice.

As shown in FIG. 13 the structure in accordance with the present invention in its main embodiment as well as in the variation described can be used for the integration of diodes.

In this case the base and collector regions are short-circuited with the epitaxial layer so as to prevent current injection on the insulation region (A₁ and C₁ in FIG. 13 represent the anode and cathode of the integrated diode).

## Claims

1. Monolithic semiconductor device with bipolar transistor structure with lateral current flow comprising integrated in the same chip:
- at least one power transistor,
- one control circuit including a bipolar transistor with a lateral current flow and which comprises
- a first buried region (3) and second regions (6) joining the perimeter of said first buried region (3) with the surface of the chip, having both a first type of conductivity and both being formed in a substrate of a second conductivity type and both acting as insulation regions of said control circuit,
- a third region (4) of the second type of conductivity opposite the first one and within said first and second regions (3,6) and reaching the surface of the chip,
- a fourth region (8) having said first type of conductivity, acting as the base region and provided within said third region (4) and extending from the chip surface,
- a fifth region (12) having the second type of conductivity, provided in said fourth region (8), acting as the collector region and extending from the chip surface, and
- a sixth region (11) having the second type of conductivity, provided in said fourth region (8), acting as the emitter region and extending from the chip surface,
characterized by the presence of:
- a seventh region (10) extending from the chip surface and having the first type of conductivity and being more highly doped than said fourth region (8), having annular geometry, surrounding and being in contact with the perimeter of said fourth region (8) and with channel-stop function.

2. Bipolar transistor structure in accordance with claim 1 characterized in that in said third region (4) there is provided an eighth region (5) of the second type of conductivity, reaching the chip surface and more highly doped than said third region (4) said fourth (8) and said seventh (10) regions being provided within said eight region (5).

3. Bipolar transistor structure in accordance with claim 2 characterized in that along the perimeter of said eighth region (5) there is a ninth region (7) of the second conductivity type and being more heavily doped than said eighth one (5), and having annular geometry with the function of channel stop.

4. Bipolar transistor structure in accordance with any of the above claims characterized in that in said fourth region (8) there is a tenth region (9) having the first type of conductivity and more highly doped than the fourth region (8), acting as the base contact region.

5. Bipolar transistor structure in accordance with claim 4 characterized in that said sixth region (11) partially overlies said tenth region (9).

6. Bipolar transistor structure in accordance with claim 4 characterized in that said sixth region (11') is entirely contained in said tenth region (9').

7. Manufacturing process for a monolithic semiconductor device in which are integrated in the same chip:
- at least one power transistor,
- a control circuit which comprises :
- a first buried region (3) and second regions (6) joining the perimeter of said first buried region (3) with the surface of the chip and having both a first type of conductivity and acting as insulation regions for said control circuit,
- a third region (4) having the second type of conductivity opposite the first one and within said first and second regions (3,6) and reaching the surface of the chip, and
- at least one bipolar transistor with lateral current flow making up part of said control circuit and provided in said third region (4), the method
comprising the following steps:
a) epitaxially growing a first layer (2) having the second type of conductivity on a substrate (1) having the same type of conductivity,
b) implanting a second type of dopant having the first conductivity type on said first layer (2),
c) diffusing the dopant having the first type of conductivity as set forth in step b) above to create said first buried region (3) having the first type of conductivity,
d) realizing a second layer (4) having the second type of conductivity by epitaxial growth on said first layer (2),
e) implanting and subsequently diffusing dopant having the second type of conductivity to create a fourth region (5) in said second layer (4) and over said first region (3),
f) implanting and subsequently diffusing dopant having the first type of conductivity to define said second regions (6) joining the perimeter of said first buried region (3) with the chip surface,
g) implanting and subsequently diffusing dopant having the second type of conductivity to provide fifth regions (7) of channel-stop along the contour of said fourth region (5),
h) forming a surface layer (111) of SiO₂ on said second layer (4),
i) opening a window in said layer (111) of SiO₂ over said fourth region (5),
l) implanting and diffusing dopant of the first type of conductivity for formation of a sixth region (8) designed to act as the base region of said control circuit transistor,
m) forming a further region (9,9',10,10') having the first type of conductivity and more highly doped than said sixth region (8) and with annular geometry and surrounding and in contact with the perimeter of said sixth region (8) comprising a seventh region (9,9') with base contact and channel-stop function and an eighth region (10,10') with channel-stop function,
n) opening two windows in said layer (111) of SiO₂ over said sixth region (8), implanting and diffusing dopant having the second type of conductivity for formation of a ninth region (11,11'), and a tenth region (12, 12'), to act as the emitter and the collector of said control circuit transistor, respectively.

8. Manufacturing process for a monolithic semiconductor device in accordance with claim 7, in which step n) is replaced these further steps:
n1) defining an opening (112) in the layer (111) of SiO₂ over said sixth region (8),
n2) depositing a layer (13) of resist,
n3) defining and implanting, shielded by the layers (13) of resist and (111) of SiO₂ , a ninth region (11') and a tenth region (12') respectively representing the emitter region and the collector region of said control circuit transistor, and
n4) removing said resist layer and diffusing said ninth region (11'), tenth region (12') and seventh region (9').

## Patentansprüche

1. Monolithisches Halbleiterelement mit bipolarer Transistorstruktur und lateralem Stromfluß, welches auf demselben Chip in integrierter Form enthält:
- mindestens einen Leistungstransistor,
- eine Steuerschaltung mit einem Bipolartransistor mit seitlichem Stromfluß umfassend
- eine erste überdeckte Zone (3) und zweite Zonen (6), welche den Umfang der ersten überdeckten Zone (3) mit der Chip-Oberfläche verbinden, wobei diese beiden Zonen einen ersten Leitungstyp aufweisen und beide in einem Substrat vom zweiten Leitungstyp ausgebildet sind und beide als Isolationszonen für die Steuerschaltung dienen,
- eine dritte Zone (4) vom zweiten, dem ersten entgegengesetzten Leitungstyp, welche innerhalb der ersten und zweiten Zone (3,6) liegt und an die Chip-Oberfläche reicht,
- eine vierte Zone (8) vom ersten Leitungstyp, welche als Basiszone dient und innerhalb der dritten Zone (4) vorgesehen ist und sich von der Chip-Oberfläche erstreckt,
- eine fünfte Zone (12) vom zweiten Leitungstyp, die in der vierten Zone (8) vorgesehen ist und als Kollektorzone wirkt und sich von der Chip-Oberfläche erstreckt, und
- eine sechste Zone (11) vom zweiten Leitungstyp, die in der vierten Zone (8) vorgesehen ist, als Emitterzone wirkt und sich von der Chip-Oberfläche erstreckt,
**gekennzeichnet durch**
eine sich von der Chip-Oberfläche erstreckende siebte Zone (10) vom ersten Leitungstyp, jedoch stärkerer Dotierung als die vierte Zone (8), die eine ringförmige Geometrie aufweist und die vierte Zone (8) umgibt und in Kontakt mit deren Umfang steht und eine Kanalunterbrechungsfunktion hat.

2. Bipolartransistorstruktur nach Anspruch 1, **dadurch gekennzeichnet**, daß in der dritten Zone (4) eine achte Zone (5) vom zweiten Leitungstyp vorgesehen ist, welche die Chip-Oberfläche erreicht und stärker als die dritte Zone (4) dotiert ist, und daß die vierte Zone (8) und die siebte Zone (10) innerhalb der achten Zone (5) gelegen sind.

3. Bipolartransistorstruktur nach Anspruch 2, **dadurch gekennzeichnet**, daß entlang des Umfangs der achten Zone (5) eine neunte Zone (7) vom zweiten Leitungstyp jedoch stärkerer Dotierung als die achte Zone (5) vorgesehen ist und eine ringförmige Geometrie mit Kanalunterbrechungsfunktion hat.

4. Bipolartransistorstruktur nach einem der vorstehenden Ansprüche, **dadurch gekennzeichnet**, daß in der vierten Zone (8) eine zehnte Zone (9) vom ersten Leitungstyp jedoch stärkerer Dotierung als die vierte Zone (8) vorgesehen ist und als Basiskontaktzone wirkt.

5. Bipolartransistorstruktur nach Anspruch 4, **dadurch gekennzeichnet**, daß die sechste Zone (11) teilweise über der zehnten Zone (9) liegt.

6. Bipolartransistorstruktur nach Anspruch 4, **dadurch gekennzeichnet**, daß die sechste Zone (11') vollständig in der zehnten Zone (9') enthalten ist.

7. Verfahren zur Herstellung eines monolithischen Halbleiterelementes, welches in integrierter Form auf demselben Chip enthält:
- mindestens einen Leistungstransistor,
- eine Steuerschaltung, die ihrerseits enthält:
- eine erste überdeckte Zone (3) und zweite Zonen (6), welche den Umfang der ersten überdeckten Zone (3) mit der Chip-Oberfläche verbinden, wobei beide Zonen von einem ersten Leitungstyp sind und als Isolationszonen für die Steuerschaltung dienen,
- eine dritte Zone (4) vom zweiten, dem ersten entgegengesetzten Leitungstyp innerhalb der ersten und zweiten Zonen (3,6), welche zur Oberfläche des Chips reichen, und
- mindestens einen Bipolartransistor mit seitlichem Stromfluß, der einen Teil der Steuerschaltung bildet und in der dritten Zone (4) vorgesehen ist,
mit folgenden Verfahrensschritten:
a) epitaxiales Wachsen einer ersten Schicht (2) vom zweiten Leitungstyp auf einem Substrat vom gleichen Leitungstyp,
b) Implantieren eines zweiten Dotiermitteltyps vom ersten Leitungstyp auf der ersten Schicht (2),
c) Diffundieren des Dotiermittels des ersten Leitungstyps wie im oben genannten Schritt b) zur Bildung der ersten überdeckten Zone (3) vom ersten Leitungstyp,
d) Ausbildung einer zweiten Schicht (4) vom zweiten Leitungstyp durch epitaxiales Wachsen auf der zweiten Schicht (2),
e) Implantieren und nachfolgendes Diffundieren von Dotiermittel des zweiten Leitungstyps zur Bildung einer vierten Zone (5) in der zweiten Schicht (4) und über der ersten Zone (3),
f) Implantieren und anschließendes Diffundieren von Dotiermittel des ersten Leitungstyps zur Bildung der zweiten Zonen (6), welche den Umfang der ersten überdeckten Zone (3) mit der Chip-Oberfläche verbinden,
g) Implantieren und nachfolgendes Diffundieren von Dotiermittel des zweiten Leitungstyps zur Bildung der fünften Kanalunterbrechungszonen (7) entlang der Kontur der vierten Zone (5),
h) Formen einer Oberflächenschicht (111) aus SiO₂ auf der zweiten Schicht (4),
i) Öffnen eines Fensters in der SiO₂-Schicht (111) über der vierten Zone,
l) Implantieren und Diffundieren von Dotiermitttel des ersten Leitungstyps zur Bildung einer sechsten Zone (8), die als Basiszone für den Steuerschaltungstransistor dient, m) Ausbildung einer weiteren Zone (9,9',10,10') vom ersten Leitungstyp mit stärkerer Dotierung als die sechste Zone (8) und mit ringförmiger Geometrie, welche den Umfang der sechsten Zone (8) in Kontakt mit ihr umgibt und eine siebte Zone (9,9') als Basiskontaktzone und Kanalunterbrechungszone und eine achte Zone (10,10') als Kanalunterbrechungszone umfaßt,
n) Öffnen von zwei Fenstern in der SiO₂-Schicht (111) über der sechsten Zone (8), Implantieren und Diffundieren von Dotiermittel des zweiten Leitungstyps zur Bildung einer neunten Zone (11,11') und einer zehnten Zone (12,12') als Emitter bzw. Kollektor des Steuerschaltungstransistors.

8. Verfahren zur Herstellung eines monolithischen Halbleiterelementes nach Anspruch 7, bei welchem Schritt n) ersetzt wird durch die folgenden weiteren Schritte:
n1) Ausbildung einer Öffnung (112) in der SiO₂-Schicht (111) über der sechsten Zone (8),
n2) Ablagern einer Resistschicht (13),
n3) Definierung und Implantierung unter Abschirmung durch die Resistschicht (13) und die SiO₂-Schicht (111), einer neunten Zone (11') und einer zehnten Zone (12'), welche die Emitterzone bzw. die Kollektorzone des Steuerschaltungstransistors darstellen, und
n4) Entfernen der Resistschicht und Diffundierung der neunten Zone (11'), der zehnten Zone (12') und der siebten Zone (9').

## Revendications

1. Dispositif semiconducteur monolithique comportant une structure de transistor bipolaire à flux de courant latéral comprenant, intégrés dans la même puce :
- au moins un transistor de puissance,
- un circuit de commande comprenant un transistor bipolaire à flux de courant latéral, qui comprend :
une première région enterrée (3) et des deuxièmes régions (6) reliant le périmètre de la première région enterrée (3) à la surface de la puce, ces régions étant d'un premier type de conductivité et étant formées dans un substrat d'un second type de conductivité, et servant ensemble de régions d'isolement du circuit de commande,
une troisième région (4) du second type de conductivité opposé au premier, disposée à l'intérieur des première et deuxièmes régions (3, 6) et atteignant la surface de la puce,
une quatrième région (8) du premier type de conductivité, constituant une région de base, formée dans la troisième région (4) et s'étendant à partir de la surface de la puce,
une cinquième région (12) du second type de conductivité formée dans la quatrième région (8), constituant une région de collecteur et s'étendant à partir de la surface de la puce, et
une sixième région (11) du second type de conductivité, formée dans la quatrième région (8), constituant une région d'émetteur et s'étendant à partir de la surface de la puce,
caractérisé par la présence d'une septième région (10) s'étendant à partir de la surface de la puce, du premier type de conductivité, plus fortement dopée que la quatrième région (8), de forme annulaire, entourant le périmètre de la quatrième région (8), contactant celle-ci, et ayant une fonction d'arrêt de canal.

2. Structure de transistor bipolaire selon la revendication 1, caractérisée en ce que, dans la troisième région (4), est formée une huitième région (5) du second type de conductivité, atteignant la surface de la puce et plus fortement dopée que la troisième région (4), les quatrième (8) et septième (10) régions étant formées dans la huitième région (5).

3. Structure de transistor bipolaire selon la revendication 2, caractérisée en ce que, le long du périmètre de la huitième région (5), se trouve une neuvième région (7) du second type de conductivité, plus fortement dopé que la huitième région (5) et ayant une forme annulaire et une fonction d'arrêt de canal.

4. Structure de transistor bipolaire selon l'une quelconque des revendications précédentes, caractérisée en ce que, dans la quatrième région (8), se trouve une dixième région (9), du premier type de conductivité, plus fortement dopée que la quatrième région (8), et constituant une région de contact de base.

5. Structure de transistor bipolaire selon la revendication 4, caractérisée en ce que la sixième région (11) recouvre partiellement la dixième région (9).

6. Structure de transistor bipolaire selon la revendication 4, caractérisée en ce que la sixième région (11') est totalement contenue dans la dixième région (9').

7. Procédé de fabrication d'un dispositif semiconducteur monolithique dans lequel sont intégrés dans la même puce :
- au moins un transistor de puissance,
- un circuit de commande qui comprend :
une première région enterrée (3) et des deuxièmes régions (6) reliant le périmètre de la première région enterrée (3) à la surface de la puce, du premier type de conductivité, et servant de régions d'isolement du circuit de commande,
une troisième région (4) du second type de conductivité opposé au premier, à l'intérieur des première et deuxièmes régions (3, 6) et atteignant la surface de la puce, et
au moins un transistor bipolaire à flux de courant latéral faisant partie du circuit de commande et formé dans la troisième région (4), ce procédé comprenant les étapes suivantes :
a) faire croître par épitaxie une première couche (2) du second type de conductivité sur un substrat (1) du même type de conductivité,
b) implanter un second type de dopant du premier type de conductivité dans la première couche (2),
c) faire diffuser le dopant du premier type de conductivité mentionné à l'étape b) créer la première région enterrée (3) du premier type de conductivité,
d) réaliser une deuxième couche (4) du second type de conductivité par croissance épitaxiale sur la première couche (2),
e) implanter et faire diffuser ensuite un dopant du second type de conductivité pour créer une quatrième région (5) dans la seconde couche (4) et au-dessus de la première région (3),
f) implanter et faire diffuser ensuite un dopant du premier type de conductivité pour définir les deuxièmes régions (6) reliant le périmètre de la première région enterrée (3) à la surface de la puce ;
g) implanter et faire diffuser ensuite un dopant du second type de conductivité pour former des cinquièmes régions (7) d'arrêt de canal le long du contour de la quatrième région (5),
h) former une couche de surface (111) de SiO₂ sur la deuxième couche (4),
i) ouvrir une fenêtre dans la couche (111) de SiO₂ au-dessus de la quatrième région,
l) implanter et faire diffuser un dopant du premier type de conductivité pour former une sixième région (8) destinée à constituer la région de base du transistor du circuit de commande,
m) former une autre région (9, 9', 10, 10') du premier type de conductivité, plus fortement dopée que la sixième région (8), de forme annulaire, entourant et en contact avec le périmètre de la sixième région (8), comprenant une septième région (9, 9') ayant une fonction de contact de base et d'arrêt de canal et une huitième région (10, 10') ayant une fonction d'arrêt de canal,
n) ouvrir deux fenêtres dans la couche (111) de SiO₂ au-dessus de la sixième région (8), implanter et faire diffuser un dopant du second type de conductivité pour former une neuvième région (11, 11') et une dixième région (12, 12') destinées à agir en tant qu'émetteur et collecteur du transistor du circuit de commande, respectivement.

8. Procédé de fabrication d'un dispositif semiconducteur monolithique selon la revendication 7, dans lequel l'étape n) est remplacée par les étapes suivantes :
n1) définir une ouverture (112) dans la couche (111) de SiO₂ au-dessus de la sixième région (8),
n2) déposer une couche (13) d'un produit photosensible,
n3) définir et implanter, en utilisant comme écran les couches (13) de produit photosensible et (111) de SiO₂, une neuvième région (11') et une dixième région (12'), constituant respectivement la région d'émetteur et la région de collecteur du transistor du circuit de commande, et
n4) enlever la couche de résine et faire diffuser la neuvième région (11'), la dixième région (12') et la septième région (9').
